# EUROPÄISCHE PATENTSCHRIFT

(11) **EP 3 516 701 B1**
(45) Veröffentlichungstag und Bekanntmachung des Hinweises auf die Patenterteilung: **22.01.2025**
(21) Anmeldenummer: 17768135.0
(22) Anmeldetag: 18.09.2017
(51) Int. Cl.: H01L 31/02

(54) **SOLARMODUL, PHOTOVOLTAIKANLAGE UND VERFAHREN ZUR SPANNUNGSBEGRENZUNG**
SOLAR MODULE, PHOVOLTAIC SYSTEM, AND VOLTAGE LIMITATION METHOD
MODULE SOLAIRE, INSTALLATION PHOTOVOLTAÏQUE ET PROCÉDÉ DE LIMITATION DE TENSION

(30) Priorität: 23.09.2016 DE 102016118039
(43) Veröffentlichungstag der Anmeldung: 31.07.2019
(73) Patentinhaber: SMA Solar Technology AG, 34266 Niestetal (DE)
(72) Erfinder: FALK, Andreas, 34131 Kassel (DE)
(86) Internationale Anmeldenummer: PCT/EP2017/073467
(87) Internationale Veröffentlichungsnummer: WO 2018/054835

(56) Entgegenhaltungen:
- EP-A1- 1 914 857
- WO-A1-2011/048122
- WO-A1-2015/095414
- DE-A1- 102011 079 074
- DE-B3- 102012 218 366

## Beschreibung

Die Erfindung betrifft ein Solarmodul, eine Photovoltaikanlage (PV-Anlage) mit einer Reihenschaltung von Solarmodulen, sowie ein Verfahren zur Spannungsbegrenzung an einem Solarmodul.

Zur kostengünstigen Erzeugung von elektrischer Energie mit Hilfe von PV-Modulen werden diese PV-Module zu Strings immer größerer Länge verbunden. Um die aufgrund der wachsenden Stringlänge steigende Spannung des Strings beherrschbar zu machen, sind Sicherheitsschaltungen erforderlich, die einen angeschlossenen Wechselrichter vor Überspannungen schützen bzw. die ein Abtrennen des Wechselrichters von den Strings zum Schutz vor der Überspannung unnötig macht.

Alternativ zu einem Abtrennen der Strings vom Wechselrichter wird in der Schrift DE102010009120 A1 vorgeschlagen, einen Teil des Strings über einen Schalter kurzzuschließen, wenn die Stringspannung einen kritischen Wert überschreitet. Hierdurch kann der verbleibende String weiterhin mit dem Wechselrichter verbunden bleiben und die Photovoltaikanlage Energie produzieren. Durch diese Lösung wird allerdings ein erhöhter Aufwand durch die Bereitstellung des zusätzlichen Kurzschlusspfades und dessen Ansteuerung verursacht.

Spannungsreduzierende Kurzschließer können aber auch nach der Schrift WO2015/095414 in PV-Module integriert werden, wodurch ein zusätzlicher Verkabelungsaufwand vermieden wird. Die Kurzschließer können jeweils ein Teilmodul bei Überspannung kurzschließen und so die Spannung an Anschlussklemmen des Solarmoduls beispielsweise auf 75% der vollen Spannung reduzieren.

Alternativ kann gemäß der Schrift EP1914857 A1 auch ein Wechselrichter mittels eines parallel zum gesamten PV-Generator angeordneten Kurzschluss-Schaltelements derart betrieben werden, dass der Generator temporär kurzgeschlossen wird, wenn eine vorgegebene Maximalspannung überschritten, und der Kurzschluss wieder aufgehoben wird, wenn die Maximalspannung unterschritten wird.

Es wäre wünschenswert, die Spannungsbegrenzung einer Reihenschaltung von Solarmodulen kontinuierlich zu gestalten, so dass bei auftretender Überspannung die Spannung nur soweit wie erforderlich abgesenkt und die Energieerzeugung der Reihenschaltung nur so wenig wie nötig eingeschränkt wird.

Es ist daher Aufgabe dieser Erfindung, Solarmodule für Strings bereitzustellen, die mit Hilfe einer Schutzbeschaltung autonom die Einhaltung von Spannungsgrenzen bei minimaler Einbuße für die Energieerzeugung sicherstellen, ohne dass ein zusätzlicher Verkabelungsaufwand des Strings erforderlich ist.

Diese Aufgabe wird gelöst durch eine Photovoltaikanlage des unabhängigen Anspruchs 1 sowie durch ein Verfahren des unabhängigen Anspruchs 8. Bevorzugte Ausführungsformen sind in den abhängigen Ansprüchen beschrieben.

In einem Aspekt betrifft die Erfindung ein Solarmodul, das eine Reihenschaltung von Solarzellen, einen Schalter, der parallel zu einem Abschnitt der Reihenschaltung angeordnet ist, und eine Ansteuerschaltung zur Ansteuerung des Schalters umfasst. Die Ansteuerschaltung ist zum getakteten Ansteuern des Schalters mit einem Tastgrad eingerichtet, wobei der Tastgrad in Abhängigkeit einer an der Reihenschaltung oder einem Teil der Reihenschaltung durch die Ansteuerschaltung (13) bei geöffnetem Schalter (12) bestimmten abfallenden Spannung bestimmt ist. Durch das getaktete Ansteuern wird die Spannung des Solarmoduls in einem ersten Zeitabschnitt reduziert, und in einem zweiten Zeitabschnitt liefert das Solarmodul eine nicht begrenzte Spannung. Der Tastgrad bestimmt somit das Verhältnis zwischen den Längen des ersten und zweiten Zeitabschnitts und hierdurch den zeitlichen Mittelwert der vom Solarmodul gelieferten Spannung. Auch wenn die Spannung des Solarmoduls zwischen zwei Werten hin und her springt, wird durch eine Nutzung vieler gleichartiger erfindungsgemäßer Solarmodule in einem String durch Überlagerung der Spannungssprünge eine zeitlich nur geringfügige Variation der Stringspannung erreicht. Hierzu werden die Ansteuerschaltungen der Solarmodule bevorzugt asynchron betrieben, um die Schaltzeitpunkte der Schalter möglichst gleichmäßig über die Zeit zu verteilen. Dies kann zum Beispiel erreicht werden, indem die Ansteuerschaltung dazu eingerichtet ist, die Frequenz des getakteten Ansteuerns zu variieren, insbesondere statistisch zu variieren. Dies kann durch einen Zufallsgenerator für die Erzeugung der Frequenz innerhalb der Ansteuerschaltung erreicht werden.

Vorteilhafterweise ist der Abschnitt der Reihenschaltung die gesamte Reihenschaltung der Solarzellen, so dass eine maximal mögliche Spannungsbegrenzung ermöglicht wird. Es kann aber auch nur ein Teilbereich der Reihenschaltung der Solarzellen den Abschnitt bilden, beispielsweise eines oder zwei von drei Teilmodulen des Solarmoduls.

Dadurch, dass die Ansteuerschaltung dazu eingerichtet ist, die Spannung über dem Teil der Reihenschaltung bei geöffnetem Schalter zu bestimmen wird die gemessene Spannung nicht von der durch das Schließen des Schalters verursachten Spannungsabsenkung beeinträchtigt und das Messergebnis ist vom verwendeten Tastgrad unabhängig.

In einer bevorzugten Ausführung der Erfindung umfasst das Solarmodul einen Trennschalter, der beim Öffnen den Abschnitt der Reihenschaltung von Anschlüssen des Solarmoduls elektrisch trennt. Dieser Trennschalter ist bevorzugt an einem Ende des durch den Schalter überbrückten Abschnitts der Reihenschaltung angeordnet. Insbesondere ist ein Anschluss des Trennschalters sowohl mit einem Anschluss des Schalters als auch mit einem Anschluss des Solarmoduls verbunden. Mit dem anderen Ende ist der Trennschalter mit der Reihenschaltung der Solarzellen verbunden. Die Ansteuerschaltung kann dazu eingerichtet sein, den Trennschalter gemeinsam mit dem getakteten Ansteuern des Schalters getaktet zu öffnen, wobei der Trennschalter vor dem Schließen des Schalters geöffnet und nach dem Öffnen des Schalters geschlossen wird. Hierdurch wird ein Entladen einer mit der Reihenschaltung von Solarzellen assoziierten Kapazität beim Schließen des Schalters vermieden. Eine solche Entladung führt zu unerwünschter thermischer Belastung des Schalters insbesondere bei hoher Schaltfrequenz.

Der Schalter und der Trennschalter werden bevorzugt als Halbleiterschalter, beispielsweise als IGBT oder MOSFET, ausgelegt und können eine intrinsische oder eine separate Freilaufdiode aufweisen. Die Freilaufdiode des Schalters ist bezogen auf die Anschlüsse des Solarmoduls parallel zu den Bypassdiode ausgerichtet, die Freilaufdiode des Trennschalters antiparallel.

Die Ansteuerschaltung, der Schalter und der Trennschalter können bevorzugt in einer Anschlussdose des Solarmoduls untergebracht sein. Eine Energieversorgung der Ansteuerschaltung erfolgt bevorzugt aus der Reihenschaltung der Solarzellen oder einem Teil derselben.

In einem weiteren Aspekt der Erfindung weist eine Photovoltaikanlage eine Mehrzahl von seriell und/oder parallel verschalteten Solarmodulen auf, von denen zumindest ein Anteil erfindungsgemäße Solarmodule sind. Auch ein Aufbau der Photovoltaikanlage ausschließlich mit erfindungsgemäßen Solarmodulen ist denkbar. Wenn nur ein Teil der Solarmodule erfindungsgemäße Solarmodule sind, und die Photovoltaikanlage parallele Strings aufweist, sollte der Anteil erfindungsgemäßer Solarmodule in den Strings gleich gewählt werden, um Rückströme in einzelnen Strings aufgrund ungleicher Spannungsreduzierung zu vermeiden.

Eine erfindungsgemäße Photovoltaikanlage kann weiterhin einen Wechselrichter aufweisen, der zur Detektion des getakteten Ansteuerns von Schaltern der erfindungsgemäßen Solarmodule als Frequenzsignal auf einer Anschlussleitung für die Mehrzahl von Solarmodulen eingerichtet ist. Ein solches Frequenzsignal ist ein Hinweis auf eine festgestellte Überspannung in Teilbereichen der Photovoltaikanlage. Insbesondere kann der Wechselrichter in Reaktion auf eine Detektion des Frequenzsignals dazu eingerichtet sein, einen Arbeitspunkt der Mehrzahl von Solarmodulen zu verschieben, beispielsweise zu einem Arbeitspunktes mit höherem Strom bzw. geringerer Spannung auf der Anschlussleitung, um so einer von Solarmodulen festgestellten Überspannung entgegenzuwirken. Insbesondere kann die Absenkung der Spannung des Arbeitspunktes schrittweise oder kontinuierlich soweit erfolgen, bis das Frequenzsignal verschwindet.

Ein zusätzlicher Aspekt der Erfindung betrifft ein Verfahren zur Spannungsbegrenzung an einem eine Reihenschaltung von Solarzellen aufweisenden Solarmodul, wobei ein Schalter parallel zu einem Abschnitt der Reihenschaltung angeordnet ist. Das Verfahren umfasst ein Bestimmen einer Spannung über einem Teil der Reihenschaltung, wobei die Bestimmung der Spannung bei geöffnetem Schalter (12) erfolgt, und ein Bestimmen eines Tastgrades in Abhängigkeit von der Spannung, sowie ein getaktetes Ansteuern des Schalters mit dem bestimmten Tastgrad. Bevorzugt wird die Spannung über dem gesamten Abschnitt der Reihenschaltung bestimmt, zu dem der Schalter parallel geschaltet ist. Um einen Einfluss des Schließens des Schalters auf die Spannungsbestimmung zu vermeiden, erfolgt die Bestimmung der Spannung bei geöffnetem Schalter.

Es ist von Vorteil, weiterhin einen derart angeordneter Trennschalter vorzusehen, dass der Trennschalter beim Öffnen den Abschnitt der Reihenschaltung von einem der Anschlüsse des Solarmoduls elektrisch trennt, wobei der Trennschalter gemeinsam mit dem getakteten Ansteuern des Schalters getaktet geöffnet und der Trennschalter vor dem Schließen des Schalters geöffnet und nach dem Öffnen des Schalters geschlossen wird. Wie bereits beschrieben wird hierdurch eine Belastung des Schalters durch das wiederholte Entladen der Kapazität des Reihenschaltungsabschnitts vermieden.

Der bestimmte Tastgrad ist in einer vorteilhaften Ausführung bei einer bestimmten Spannung unterhalb eines vorgegebenen Spannungsgrenzwerts Null, so dass der Schalter nicht getaktet betrieben wird. Oberhalb des Spannungsgrenzwerts weist der Tastgrad einen Minimalwert von mindestens 5%, bevorzugt mindestens 10% auf. Mit steigender Spannung kann sich der Tastgrad dann weiter bis zu einem Maximalwert erhöhen, der bei 100% liegen kann, aber auch geringer gewählt sein kann, zum Beispiel zu 95%. Bei einer Wahl von 100% als Maximalwert sollte aber dennoch sichergestellt und mit umfasst sein sein, dass zumindest zur Bestimmung der Spannung über dem Abschnitt der Reihenschaltung der Schalter wiederholt kurzzeitig geöffnet wird.

Um einen geringen Rippel der Spannung innerhalb der Photovoltaikanlage zu erreichen, ist eine hohe Taktfrequenz von Vorteil. Es hat sich gezeigt, dass beispielsweise eine Taktfrequenz von 2 kHz ausreichend ist, um bei üblicherweise verwendeten Zwischenkreiskapazitäten innerhalb des Wechselrichters bereits eine niedrige Restschwankung der Eingangsspannung des Wechselrichters zu erreichen. Andererseits führt eine möglichst geringe Taktfrequenz zu geringen Schaltverlusten, da beim Schließen des Schalters in einem Solarmodul sich die Arbeitspunkte der anderen Solarmodule des Strings entsprechend der Spannungsreduktion in dem einen Solarmodul verändern. Die Veränderung der Arbeitspunkte der anderen Solarmodule führen zu einem Umladen der mit den Solarzellen dieser Solarmodule verknüpften Generatorkapazität und damit zu zusätzlichen Leistungsverlusten. Ein Kompromiss zwischen diesen Verlusten und dem verbleibenden Spannungsrippel wird typischerweise in einem Bereich der Taktfrequenz zwischen 200 Hz und 2 kHz erreicht.

Um eine Gleichzeitigkeit der Schaltvorgänge des Schalters mit anderen Schaltern in anderen erfindungsgemäßen Solarmodulen zu minimieren und stattdessen eine möglichst gleichmäßige Verteilung der Schaltzeitpunkte zu erreichen, kann die Frequenz des getakteten Ansteuerns variiert, insbesondere statistisch variiert werden. Eine statistische Variation der Frequenz kann durch einen Zufallsgenerator als Teil der Ansteuerschaltung erreicht werden.

Im Folgenden wird die Erfindung mithilfe von Figuren dargestellt, von denen
- Fig. 1: eine erfindungsgemäße Ausführung eines Solarmoduls,
- Fig. 2: eine weitere erfindungsgemäße Ausführung eines Solarmoduls,
- Fig. 3: einen Zeitverlauf von Schaltvorgängen von in dem erfindungsgemäßen Solarmodul verwendeten Schaltern
- Fig. 4: ein Diagramm zur Veranschaulichung der Bestimmung eines Tastgrades in Abhängigkeit einer Spannung, sowie
- Fig. 5: eine Photovoltaikanlage unter Verwendung der erfindungsgemäßen Solarmodule.

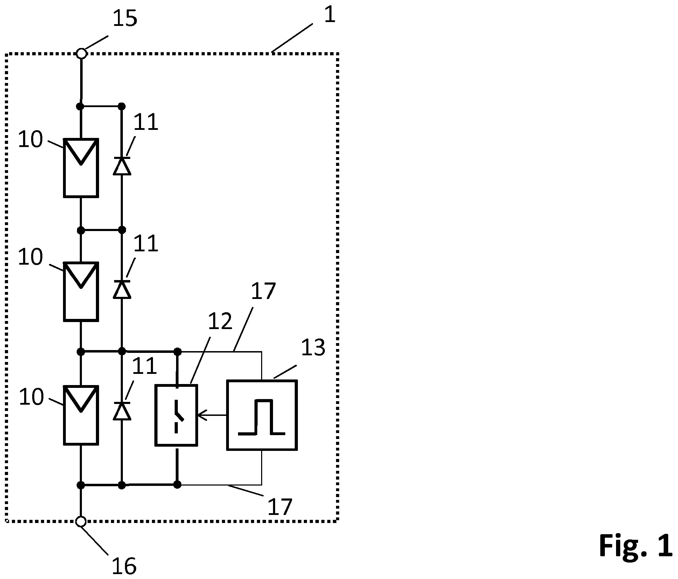

Fig. 1 zeigt ein erfindungsgemäßes Solarmodul 1 mit einem ersten Anschluss 15 und einem zweiten Anschluss 16. Zwischen den Anschlüssen 15, 16 ist eine Reihenschaltung von Solarzellen 10 angeordnet, denen jeweils abschnittsweise eine Bypassdiode 11 parallel geschaltet ist. Einem Abschnitt der Solarzellen 10, beispielsweise einem von drei Teilmodulen, aus denen das Solarmodul 1 gebildet ist, ist weiterhin ein Schalter 12 parallel geschaltet, der den Abschnitt der Solarzellen 10 überbrückt, wenn eine Ansteuereinheit 13 den Schalter 12 schließt, also leitend schaltet. Die Ansteuerschaltung 13 ist dazu eingerichtet, den Schalter 12 mit einem Tastgrad getaktet anzusteuern, wobei der Tastgrad in Abhängigkeit von einer an Eingängen 17 der Ansteuerschaltung 13 anliegenden Spannung bestimmt wird. Die Eingänge 17 sind derart mit der Reihenschaltung von Solarzellen 10 verbunden, dass sie die Spannung über einem Teil der Solarzellen 10 erfassen. Der Teil kann, wie hier gezeigt, identisch mit dem Abschnitt der Solarzellen 10 sein, kann aber auch die Spannung über einen anderen Teil der Reihenschaltung der Solarzellen 10 oder gar über die gesamte Reihenschaltung erfassen. Die Erfassung der Spannung kann zeitlich abgestimmt mit dem Takten des Schalters 12 erfolgen, insbesondere kann sie dann erfolgen, wenn der Schalter 12 geöffnet ist.

Vorteilhafterweise bezieht die Ansteuerschaltung 13 die zum Betrieb erforderliche elektrische Energie ebenfalls über die Eingänge 17, also aus dem Teil der Reihenschaltung, mit dem die Eingänge 17 verbunden sind. Hierdurch ist keine weitere Energiequelle für die Ansteuerschaltung erforderlich.

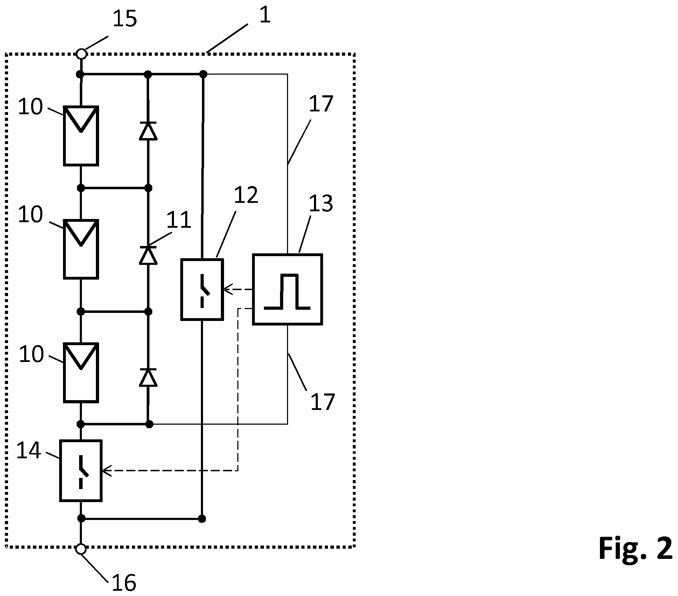

Die in Fig. 2 gezeigte Ausführungsform eines erfindungsgemäßen Solarmoduls 1 unterscheidet sich zunächst von dem Solarmodul 1 aus Fig. 1 dadurch, dass der Schalter 12 nunmehr parallel zur gesamten Reihenschaltung von Solarzellen 10 angeordnet ist und damit das gesamte Solarmodul 1 überbrückt. Weiterhin wurde die Reihenschaltung von Solarzellen 10 ergänzt durch einen Trennschalter 14, der ebenfalls von der Ansteuerschaltung 13 angesteuert wird. Der Trennschalter 14 ist in dem vom Schalter 12 überbrückten Abschnitt der Reihenschaltung von Solarzellen 10 grundsätzlich an beliebiger Stelle angeordnet, hier ist er direkt mit dem Anschluss 16 des Solarmodul 1 verbunden.

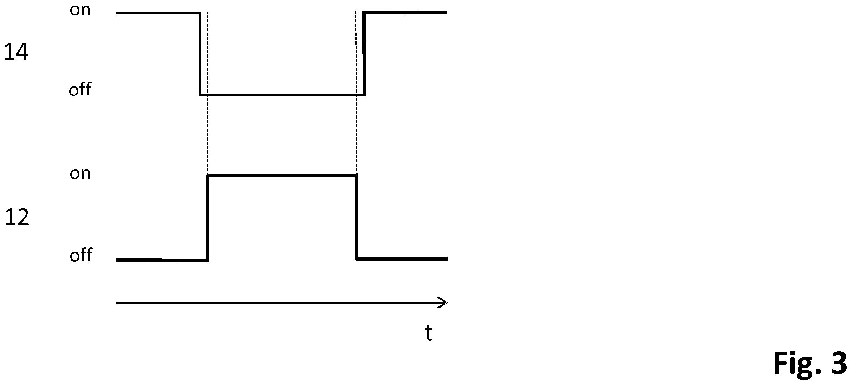

In einer bevorzugten Ausführung wird der Trennschalter 14 gemeinsam mit dem Schalter 12 von der Ansteuerschaltung 13 getaktet betrieben, wobei der Trennschalter 14 vor dem Schließen des Schalters 12 geöffnet und nach dem Öffnen des Schalters 12 wieder geschlossen wird. Der Trennschalter 14 ist also während der gesamten Zeit geöffnet, in der der Schalter 12 den Abschnitt der Reihenschaltung der Solarzellen 10 überbrückt. Dieser Sachverhalt ist in dem Schaltverlauf in Fig. 3 dargestellt. Das obere Diagramm zeigt den Zeitverlauf der Schaltzustände des Trennschalters 14, das untere Diagramm den Zeitverlauf der Schaltzustände des Schalters 12.

Der Einsatz des Trennschalters 14 ist besonders dann von Vorteil, wenn die Reihenschaltung von Solarzellen 10 eine hohe Kapazität aufweist, die beim Schließen des Schalters 12 über diesen entladen und zu einer erheblichen thermischen Belastung des Schalters führen würde, was durch das Öffnen des Trennschalters 14 vermieden wird.

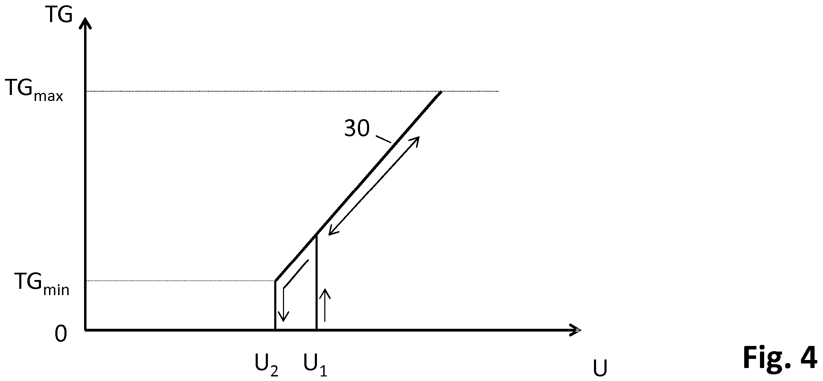

In Fig. 4 ist dargestellt, wie die Ansteuerschaltung 13 den zu verwendenden Tastgrad auf der Ordinate aus der Spannung an dem Teil der Reihenschaltung der Solarzellen 10 auf der Abszisse des Diagramms bestimmt, der mit den Eingängen 17 der Ansteuerschaltung 13 verbunden ist. Unterhalb eines ersten Schwellwerts U₁ der Spannung ist der Tastgrad Null, das heißt der Schalter 12 bleibt dauerhaft geöffnet und der Trennschalter 14, falls vorhanden, geschlossen. Bei Erreichen des ersten Schwellwerts U₁ beginnt ein getaktetes Betreiben des Schalters 12 beziehungsweise des Trennschalters 14 mit einem Tastgrad, der größer oder gleich einem minimalen Tastgrad TGₘᵢₙ ist. Oberhalb des ersten Schwellwerts U₁ wird der Tastgrad anhand einer vorgegebenen Kennlinie 30 gewählt und kann bis zu einem maximalen Tastgrad TGₘₐₓ, beispielsweise 95 %, steigen. In Fig. 4 ist eine lineare Kennlinie 30 gezeigt, es kann aber auch eine andere Kennlinie, insbesondere eine monoton steigende Kennlinie, verwendet werden. Die Kennlinie 30 erreicht bei einem zweiten Schwellwert U₂ den minimalen Tastgrad TGₘᵢₙ, beispielsweise 5%. Der zweite Schwellwert U₂ ist kleiner oder gleich dem ersten Schwellwert U₁. Fällt die Spannung an den Eingängen 17 der Ansteuerschaltung 13 unter den zweiten Schwellwert U₂, so wird wieder ein Tastgrad von Null angewendet, das getaktete Betreiben des Schalters 12 endet also. Es ist auch möglich, den minimalen Tastgrad gleich Null zu setzen oder entsprechend der minimal möglichen Pulsweite des Schalters 12 zu wählen.

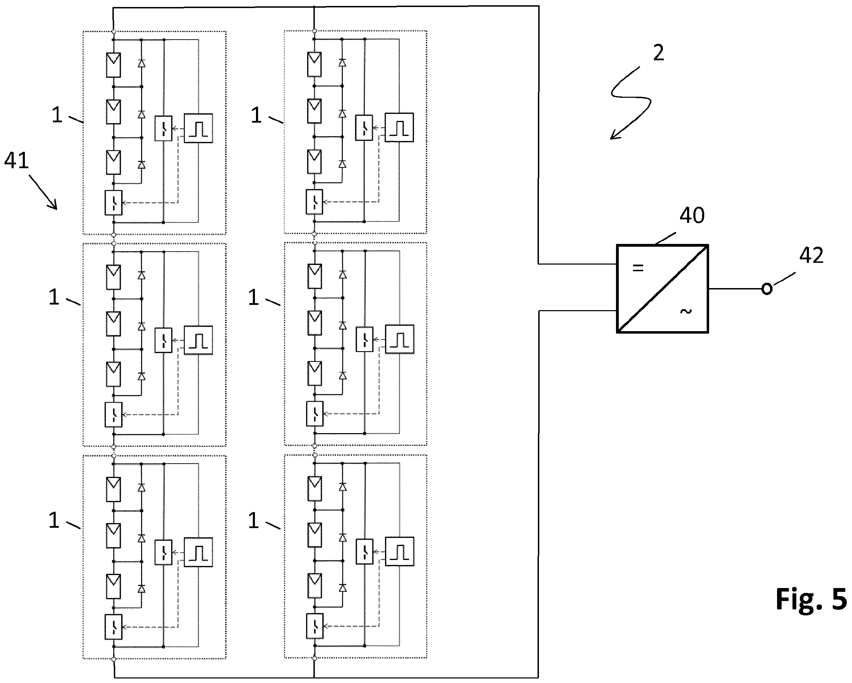

Fig. 5 zeigt die Verwendung der erfindungsgemäßen Solarmodule als Teile einer Photovoltaikanlage 2. Die Solarmodule 1 sind als String 41 reihenverschaltet, wobei mehrere Strings 41 zueinander parallel zwischen Anschlussleitungen an einen Wechselrichter 40 geschaltet sein können. Der Wechselrichter 40 wandelt die von den Strings 41 erzeugte Gleichstromleistung in eine Wechselstromleistung zur Einspeisung in ein an einem Netzanschlusspunkt 42 angeschlossenes Netz um. Die maximale Stringspannung wird durch den Einsatz der erfindungsgemäßen Solarmodule 1 eigenständig von diesen begrenzt, indem sie durch das getaktete Betreiben der Schalter 12 beziehungsweise Trennschalter 14 im Falle einer Spannung oberhalb des ersten Schwellwerts U₁ ihre Spannung automatisch reduzieren. Hierdurch wird es möglich, eine Länge des oder der Strings 41 derart zu verlängern, dass die maximale theoretische Leerlaufspannung, also die Leerlaufspannung ohne getaktetes Betreiben der Schalter, des oder der Strings 41 über die maximale Eingangsspannung des Wechselrichters 40 hinausgeht. Dies ist möglich, weil die Solarmodule 1 durch den Einsatz der Erfindung verhindern, dass die maximale Leerlaufspannung erreicht wird. Durch die erhöhte Stringlänge wird eine kostengünstigere Photovoltaikanlage 2 ermöglicht.

### Bezugszeichenliste

- 1: Solarmodul
- 2: Photovoltaikanlage
- 10: Solarzelle
- 11: Bypassdiode
- 12: Schalter
- 13: Ansteuerschaltung
- 14: Schalter
- 15, 16: Anschluss
- 17: Eingang
- 30: Kennlinie
- 40: Wechselrichter
- 41: String
- 42: Netzanschlusspunkt

## Patentansprüche

1. Photovoltaikanlage (2) mit einer Mehrzahl von seriell und/oder parallel verschalteten Solarmodulen (1), wobei die Mehrzahl von Solarmodulen (1) jeweils umfasst:
- eine Reihenschaltung von Solarzellen (10),
- einen Schalter (12), der parallel zu einem Abschnitt der Reihenschaltung angeordnet ist, und
- eine Ansteuerschaltung (13) des Schalters (12)
**dadurch gekennzeichnet, dass**
die Ansteuerschaltung (13) zum getakteten Ansteuern des Schalters (12) mit einem Tastgrad eingerichtet ist, wobei der Tastgrad in Abhängigkeit einer an der Reihenschaltung oder einem Teil der Reihenschaltung durch die Ansteuerschaltung (13) bei geöffnetem Schalter (12) bestimmten abfallenden Spannung bestimmt ist.

2. Photovoltaikanlage (2) nach Anspruch 1, wobei der Abschnitt der Reihenschaltung die gesamte Reihenschaltung ist.

3. Photovoltaikanlage (2) nach Anspruch 1 oder 2, wobei der Abschnitt der Reihenschaltung identisch mit dem Teil der Reihenschaltung ist.

4. Photovoltaikanlage (2) nach einem der vorangehenden Ansprüche, weiterhin umfassend einen derart angeordneten Trennschalter (14), dass der Trennschalter (14) beim Öffnen den Abschnitt der Reihenschaltung von einem der Anschlüsse (15, 16) des Solarmoduls (1) elektrisch trennt.

5. Photovoltaikanlage (2) nach Anspruch 4, wobei die Ansteuerschaltung eingerichtet ist, den Trennschalter (14) gemeinsam mit dem getakteten Ansteuern des Schalters (12) getaktet zu öffnen, wobei der Trennschalter (14) vor dem Schließen des Schalters (12) geöffnet und nach dem Öffnen des Schalters (12) geschlossen wird.

6. Photovoltaikanlage (2) nach einem der vorangehenden Ansprüche, wobei die Ansteuerschaltung (13) dazu eingerichtet ist, die Frequenz des getakteten Schließens zu variieren, insbesondere statistisch zu variieren.

7. Photovoltaikanlage (2) nach einem der vorangehenden Ansprüche, weiterhin aufweisend einen Wechselrichter (40), der zur Detektion des getakteten Ansteuerns von Schaltern (12) der Solarmodule (1) als Frequenzsignal auf einer Anschlussleitung für die Mehrzahl von Solarmodulen (1) eingerichtet ist, wobei der Wechselrichter (40) zur Verschiebung eines Arbeitspunktes der Mehrzahl von Solarmodulen (1), insbesondere zu einer Verschiebung des Arbeitspunktes zu höherem Strom auf der Anschlussleitung, in Reaktion auf eine Detektion des Frequenzsignals eingerichtet ist.

8. Verfahren zur Spannungsbegrenzung in einer Photovoltaikanlage (2) nach einem der vorhergehenden Ansprüche, umfassend die Schritte:
- Bestimmen einer Spannung über einem Teil der Reihenschaltung, wobei die Bestimmung der Spannung bei geöffnetem Schalter (12) erfolgt,
- Bestimmen eines Tastgrades in Abhängigkeit von der Spannung
- getaktetes Schließen des Schalters (12) mit dem Tastgrad.

9. Verfahren nach Anspruch 8, wobei die Spannung über dem Abschnitt der Reihenschaltung bestimmt wird.

10. Verfahren nach einem der Ansprüche 8 bis 9, wobei weiterhin ein derart angeordneter Trennschalter (14) vorgesehen ist, dass der Trennschalter (14) beim Öffnen den Abschnitt der Reihenschaltung von einem Anschluss (15, 16) des Solarmoduls (1) elektrisch trennt, wobei der Trennschalter (14) gemeinsam mit dem getakteten Schließen des Schalters (12) getaktet geöffnet und der Trennschalter (14) vor dem Schließen des Schalters (12) geöffnet und nach dem Öffnen des Schalters (12) geschlossen wird.

11. Verfahren nach einem der Ansprüche 8 bis 10, wobei der bestimmte Tastgrad bei einer vorgegebenen Spannung unterhalb eines vorgegebenen Spannungsgrenzwerts Null ist und oberhalb des Spannungsgrenzwerts einen Minimalwert von mindestens 5%, bevorzugt mindestens 10% aufweist.

12. Verfahren nach einem der Ansprüche 8 bis 11, wobei das getaktete Schließen mit einer Frequenz von mehr als 200 Hz und bevorzugt weniger als 2 kHz erfolgt.

13. Verfahren nach einem der Ansprüche 8 bis 12, wobei die Frequenz des getakteten Schließens variiert, insbesondere statistisch variiert wird.

## Claims

1. A photovoltaic installation (2) comprising a plurality of solar modules (1) interconnected in series and/or in parallel, wherein each of the plurality of solar modules (1) comprises:
- a series circuit of solar cells (10),
- a switch (12), being arranged in parallel with a section of the series circuit, and
- an actuation circuit (13) of the switch (12),
**characterized in that**
the actuation circuit (13) is configured for clocked actuation of the switch (12) with a duty cycle, wherein the duty cycle is determined depending on a voltage dropped at the series circuit or a portion of the series circuit by the actuation circuit (13) with opened switch (12).

2. The photovoltaic installation (2) as claimed in claim 1, wherein the section of the series circuit is the entire series circuit.

3. The photovoltaic installation (2) as claimed in claim 1 or 2, wherein the section of the series circuit is identical to the portion of the series circuit.

4. The photovoltaic installation (2) as claimed in one of the preceding claims, further comprising a circuit breaker (14) arranged in such a way that, when opened, the circuit breaker (14) electrically isolates the section of the series circuit from one of the terminals (15, 16) of the solar module (1).

5. The photovoltaic installation (2) as claimed in claim 4, wherein the actuation circuit is configured to open the circuit breaker (14) in a clocked manner together with the clocked actuation of the switch (12), wherein the circuit breaker (14) is opened before the switch (12) is closed and is closed after the switch (12) is opened.

6. The photovoltaic installation (2) as claimed in one of the preceding claims, wherein the actuation circuit (13) is configured to vary the frequency of the clocked closure, in particular to vary said frequency in a statistical manner.

7. The photovoltaic installation (2) as claimed in one of the preceding claims, further comprising an inverter (40) configured to detect the clocked actuation of switches (12) of the solar modules (1) as a frequency signal on a connection line for the plurality of solar modules (1), wherein the inverter (40) is configured to shift an operating point of the plurality of solar modules (1), in particular to shift the operating point to a higher current on the connection line, in response to detection of the frequency signal.

8. A method for voltage limitation in a photovoltaic installation (2) as claimed in one of the preceding claims, comprising the steps of:
- determining a voltage across a portion of the series circuit, wherein the determining of the voltage is performed at opened switch (12),
- determining a duty cycle depending on the voltage,
- closing the switch (12) in a clocked manner with the duty cycle.

9. The method as claimed in claim 8, wherein the voltage across the section of the series circuit is determined.

10. The method as claimed in one of claims 8 to 9, wherein a circuit breaker (14) is furthermore provided, arranged in such a way that, when opened, the circuit breaker (14) electrically isolates the section of the series circuit from a terminal (15, 16) of the solar module (1), wherein the circuit breaker (14) is opened in a clocked manner together with the clocked closure of the switch (12) and the circuit breaker (14) is opened before the switch (12) is closed and is closed after the switch (12) is opened.

11. The method as claimed in one of claims 8 to 10, wherein, at a prescribed voltage below a prescribed voltage limit value, the determined duty cycle is zero and, above the voltage limit value, has a minimum value of at least 5%, preferably at least 10%.

12. The method as claimed in one of claims 8 to 11, wherein the clocked closure takes place at a frequency of more than 200 Hz and preferably less than 2 kHz.

13. The method as claimed in one of claims 8 to 12, wherein the frequency of the clocked closure is varied, in particular is varied in a statistical manner.

## Revendications

1. Installation photovoltaïque (2) comprenant plusieurs modules solaires (1) interconnectés en série et/ou en parallèle, dans laquelle chacun des modules solaires (1) comprend :
- un circuit en série de cellules solaires (10),
- un interrupteur (12), disposé en parallèle avec une section du circuit en série, et
- un circuit d'actionnement (13) de l'interrupteur (12),
**caractérisé par le fait que**
le circuit d'actionnement (13) est configuré pour un actionnement cadencé de l'interrupteur (12) avec un rapport cyclique, le rapport cyclique étant déterminé en fonction d'une tension chutée au niveau du circuit en série ou d'une partie du circuit en série par le circuit d'actionnement (13) avec l'interrupteur (12) ouvert.

2. Installation photovoltaïque (2) selon la revendication 1, dans laquelle la section du circuit en série est le circuit en série entier.

3. Installation photovoltaïque (2) selon la revendication 1 ou 2, dans laquelle la section du circuit en série est identique à la partie du circuit en série.

4. Installation photovoltaïque (2) selon l'une des revendications précédentes, comprenant en outre un disjoncteur (14) disposé de telle sorte que, lorsqu'il est ouvert, le disjoncteur (14) isole électriquement la section du circuit en série de l'une des bornes (15, 16) du module solaire (1).

5. Installation photovoltaïque (2) selon la revendication 4, dans laquelle le circuit d'actionnement est configuré pour ouvrir le disjoncteur (14) de manière synchronisée avec l'actionnement synchronisé de l'interrupteur (12), le disjoncteur (14) étant ouvert avant la fermeture de l'interrupteur (12) et fermé après l'ouverture de l'interrupteur (12).

6. Installation photovoltaïque (2) selon l'une des revendications précédentes, dans laquelle le circuit d'actionnement (13) est configuré pour faire varier la fréquence de la fermeture cadencée, notamment pour faire varier cette fréquence de manière statistique.

7. Installation photovoltaïque (2) selon l'une des revendications précédentes, comprenant en outre un onduleur (40) configuré pour détecter l'actionnement cadencé des interrupteurs (12) des modules solaires (1) en tant que signal de fréquence sur une ligne de connexion pour la pluralité de modules solaires (1), dans laquelle l'onduleur (40) est configuré pour déplacer un point de fonctionnement de la pluralité de modules solaires (1), en particulier pour déplacer le point de fonctionnement vers un courant plus élevé sur la ligne de connexion, en réponse à la détection du signal de fréquence.

8. Procédé de limitation de tension dans une installation photovoltaïque (2) selon l'une des revendications précédentes, comprenant les étapes de:
- déterminer une tension aux bornes d'une partie du circuit en série, la détermination de la tension étant effectuée au niveau d'un interrupteur ouvert (12),
- déterminer un rapport cyclique en fonction de la tension,
- fermer l'interrupteur (12) de manière synchronisée avec le rapport cyclique.

9. Procédé selon la revendication 8, dans laquelle la tension à travers la section du circuit en série est déterminée.

10. Procédé selon l'une des revendications 8 à 9, dans lequel un disjoncteur (14) est en outre prévu, disposé de telle sorte que, lorsqu'il est ouvert, le disjoncteur (14) isole électriquement la section du circuit en série d'une borne (15, 16) du module solaire (1), dans lequel le disjoncteur (14) est ouvert de manière cadencée en même temps que la fermeture cadencée de l'interrupteur (12) et le disjoncteur (14) est ouvert avant la fermeture de l'interrupteur (12) et est fermé après l'ouverture de l'interrupteur (12).

11. Procédé selon l'une des revendications 8 à 10, dans lequel, à une tension prescrite inférieure à une valeur limite de tension prescrite, le rapport cyclique déterminé est nul et, au-dessus de la valeur limite de tension, a une valeur minimale d'au moins 5%, de préférence d'au moins 10%.

12. Procédé selon l'une des revendications 8 à 11, dans lequel la fermeture cadencée a lieu à une fréquence supérieure à 200 Hz et de préférence inférieure à 2 kHz.

13. Procédé selon l'une des revendications 8 à 12, dans lequel la fréquence de la fermeture cadencée varie, notamment de manière statistique.
